# FASCICULE DE BREVET EUROPEEN

(11) **EP 3 163 595 B1**
(45) Date de publication et mention de la délivrance du brevet: **16.05.2018**
(21) Numéro de dépôt: 16195363.3
(22) Date de dépôt: 24.10.2016
(51) Int. Cl.: H01H 61/02, H01H 37/10, H01H 37/44, H01H 37/48, H01H 37/60, H01H 37/76

(54) **ORGANE DE COUPURE A COMMANDE THERMIQUE ET COMPTEUR ELECTRIQUE EQUIPE DE L'ORGANE DE COUPURE**
SCHALTVORRICHTUNG MIT THERMISCHEM AUSLÖSER UND STROMZÄHLER MIT DIESER SCHALTVORRICHTUNG
SWITCHING DEVICE WITH THERMAL TRIPPING MEANS AND ELECTRIC METER EQUIPPED THEREWITH

(30) Priorité: 29.10.2015 FR 1560392
(43) Date de publication de la demande: 03.05.2017
(73) Titulaire: SAGEMCOM ENERGY & TELECOM SAS, 92500 Rueil-Malmaison (FR)
(72) Inventeur: TEBOULLE, Henri, 92500 RUEIL MALMAISON (FR); HERGAULT, Stéphane, 92500 RUEIL MALMAISON (FR)
(74) Mandataire: Lavaud, Thomas

(56) Documents cités:
- DE-A1- 1 639 272
- JP-A- H02 106 838
- SU-A1- 660 119
- US-A- 4 307 367
- US-A- 5 977 858
- US-A1- 2004 032 000

## Description

L'invention concerne le domaine des compteurs d'énergie électrique.

### ARRIERE PLAN DE L'INVENTION

Les compteurs d'énergie électrique modernes sont des compteurs électroniques dits « intelligents » qui sont bien sûr adaptés à mesurer une quantité d'énergie électrique fournie par un distributeur à une installation électrique via un réseau de distribution, mais qui sont aussi capables de réaliser un certain nombre de fonctions complémentaires : gestion des tarifs par réception d'ordres, relève et programmation à distance, télé-information client, etc.

Un tel compteur comporte parfois un organe de coupure monté sur un conducteur de phase et permettant de sélectivement connecter et déconnecter, à distance, l'installation électrique du réseau de distribution.

L'organe de coupure est notamment utilisé pour protéger l'installation électrique en s'ouvrant lorsqu'il est soumis à une surtension accidentelle provenant du réseau de distribution, et en se refermant suite à cette surtension accidentelle sur commande d'un opérateur du distributeur. L'organe de coupure est aussi utilisé pour couper ou rétablir à distance l'alimentation de l'installation électrique en cas, par exemple, de résiliation de l'abonnement de l'utilisateur de l'installation électrique ou de non-paiement de l'énergie électrique consommée, sans qu'il soit nécessaire d'envoyer du personnel sur place.

Il est souhaitable que l'organe de coupure puisse s'ouvrir et se fermer de manière franche et rapide, ce qui permet de limiter la formation d'arcs électriques qui fragilisent et réduisent la durée de vie de l'organe de coupure, et qui dégradent les équipements de l'installation électrique.

On connaît notamment du document US 5 977 858 A un organe de coupure destiné à sélectivement connecter entre elles et déconnecter deux bornes d'un circuit électrique, l'organe de coupure comportant :
- une lame déformable adaptée à prendre une forme stable de connexion dans laquelle une portion centrale de la lame déformable est agencée pour connecter entre elles les deux bornes et une forme stable de déconnexion dans laquelle la portion centrale est agencée pour déconnecter les deux bornes ;
- un premier actionneur et un deuxième actionneur qui sont commandés thermiquement et qui sont agencés pour agir de manière antagoniste sur la lame déformable pour la déformer, de sorte que le premier actionneur est adapté à amener la lame déformable dans la forme stable de connexion et le deuxième actionneur est adapté à amener la lame déformable dans la forme stable de déconnexion.

Il est aussi souhaitable de protéger l'organe de coupure contre une tentative de fraude magnétique visant à perturber le fonctionnement de l'organe de coupure depuis l'extérieur du compteur à l'aide d'un puissant aimant. Une telle tentative de fraude consiste par exemple à forcer l'organe de coupure à demeurer dans un état fermé alors que le distributeur a commandé l'ouverture de l'organe de coupure après avoir constaté des impayés de facture. Ce type de tentative de fraude est bien sûr coûteux pour le distributeur mais peut aussi présenter des risques pour le réseau de distribution. En effet, dans le cas où une surtension est générée par l'installation du fraudeur, l'organe de coupure ne pourra pas s'ouvrir pour protéger le réseau de distribution qui risque alors d'être endommagé par les conséquences de cette surtension (qui est susceptible de provoquer un incendie sur le réseau de distribution).

### OBJET DE L'INVENTION

L'invention a pour objet un organe de coupure adapté à s'ouvrir et à se fermer de manière franche et rapide, et dont le fonctionnement n'est pas susceptible d'être perturbé par une tentative de fraude magnétique.

### RESUME DE L'INVENTION

En vue de la réalisation de ce but, on propose un organe de coupure destiné à sélectivement connecter entre elles et déconnecter deux bornes d'un circuit électrique, l'organe de coupure comportant :
- une lame déformable adaptée à prendre une forme stable de connexion dans laquelle une première extrémité de la lame déformable est agencée pour connecter entre elles les deux bornes et une forme stable de déconnexion dans laquelle la première extrémité est agencée pour déconnecter les deux bornes ;
- un premier actionneur et un deuxième actionneur qui sont commandés thermiquement et qui sont agencés pour agir de manière antagoniste sur une deuxième extrémité de la lame déformable pour déformer la lame déformable, de sorte que le premier actionneur est adapté à amener la lame déformable dans la forme stable de connexion et le deuxième actionneur est adapté à amener la lame déformable dans la forme stable de déconnexion.

L'utilisation de la lame déformable permet d'obtenir une ouverture et une fermeture franches et rapides de l'organe de coupure. De plus, comme le premier actionneur et le deuxième actionneur sont commandés thermiquement, leur fonctionnement ainsi que celui de l'organe de coupure de l'invention ne peuvent pas être perturbés par une tentative de fraude magnétique.

L'invention sera mieux comprise à la lumière de la description qui suit d'un mode de mise en oeuvre particulier non limitatif de l'invention.

### BREVE DESCRIPTION DES DESSINS

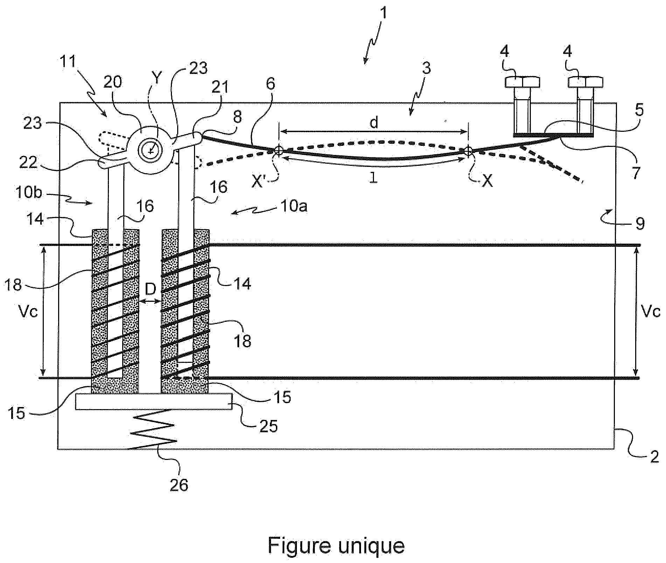

Il sera fait référence au dessin annexé de la figure unique, qui représente un compteur électrique équipé de l'organe de coupure de l'invention.

### DESCRIPTION DETAILLEE DE L'INVENTION

En référence à la figure unique, l'invention est ici mise en oeuvre dans un compteur électrique 1 destiné à mesurer une énergie électrique qui est fournie par un réseau de distribution situé en amont du compteur 1 et qui est consommée par une installation électrique située en aval du compteur 1. L'énergie électrique est transmise à l'installation électrique par une ligne électrique comprenant un conducteur de phase et un conducteur de neutre auxquels est raccordé le compteur 1.

Le compteur 1 comporte un boîtier 2 et un organe de coupure 3 qui est monté sur le conducteur de phase à l'intérieur du compteur 1. L'organe de coupure 3 permet de sélectivement connecter et déconnecter, à distance, l'installation électrique du réseau de distribution.

La connexion et la déconnexion de l'installation électrique du réseau de distribution consistent respectivement à connecter entre elles et à déconnecter l'une de l'autre deux bornes électriques 4 situées sur le conducteur de phase.

La connexion entre elles des deux bornes 4 est réalisée en amenant un contact conducteur mobile 5 de l'organe de coupure 3 au contact des deux bornes 4 simultanément, ce qui ferme un circuit électrique comprenant le conducteur de phase (situation en traits pleins sur la figure unique).

Au contraire, la déconnexion des deux bornes 4 est réalisée en éloignant le contact 5 des deux bornes 4, ce qui ouvre le circuit électrique comprenant le conducteur de phase (situation en pointillés sur la figure unique).

La mise en contact du contact 5 avec les deux bornes 4 et l'éloignement du contact 5 des deux bornes 4 sont obtenus grâce à une lame déformable 6 de l'organe de coupure 3. La lame déformable 6 est ici une lame métallique fine et étroite qui comporte une première extrémité 7, une deuxième extrémité 8 et deux axes de pivotement X, X'.

Le contact 5 est solidaire de la première extrémité 7 de la lame 6.

Les deux axes de pivotement X, X' sont deux axes parallèles qui sont fixés libres en pivotement sur une face interne 9 du boîtier 2 du compteur 1 et qui s'étendent perpendiculairement à la face interne 9.

Une distance d entre les deux axes de pivotement X, X' est inférieure à une longueur 1 d'une portion longitudinale de la lame 6 qui s'étend entre les deux axes de pivotement X, X' de sorte que ladite portion est élastiquement incurvée entre les deux axes de pivotement X, X'.

La lame 6 est ainsi adaptée à prendre deux formes stables (selon que l'incurvation se trouve d'un côté ou de l'autre du plan contenant les axes de pivotement X, X') et à passer de manière franche et très rapide d'une forme à l'autre. Ces deux formes sont ici appelées forme de connexion (en traits pleins sur la figure unique) et forme de déconnexion (en traits pointillés sur la figure unique).

Lorsque la lame 6 est dans la forme de connexion, la première extrémité 7 de la lame 6 est dans une position haute rapprochée des deux bornes 4 et le contact 5 est en contact simultanément avec les deux bornes 4 et donc connecte les deux bornes 4 entre elles.

Lorsque la lame 6 est dans la forme de déconnexion, la première extrémité 7 de la lame 6 est dans une position basse éloignée des deux bornes 4 et le contact 5 est éloigné des deux bornes 4 qui sont donc déconnectées l'une de l'autre.

Pour amener la lame 6 dans la forme de connexion et dans la forme de déconnexion, l'organe de coupure 3 comporte un premier actionneur 10a, un deuxième actionneur 10b et un basculeur intermédiaire 11.

Le premier actionneur 10a, le deuxième actionneur 10b et le basculeur intermédiaire 11 agissent de manière antagoniste sur la deuxième extrémité 8 de la lame 6.

Pour amener la lame 6 dans la forme de connexion et donc la première extrémité 7 de la lame 6 dans la position haute, le premier actionneur 10a, le deuxième actionneur 10b et le basculeur intermédiaire 11 sont agencés pour amener la deuxième extrémité 8 de la lame 6 dans une position haute.

Pour amener la lame 6 dans la forme de déconnexion et donc la première extrémité 7 de la lame 6 dans la position basse, le premier actionneur 10a, le deuxième actionneur 10b et le basculeur intermédiaire 11 sont agencés pour amener la deuxième extrémité 8 de la lame 6 dans une position basse.

Le premier actionneur 10a et le deuxième actionneur 10b comportent chacun un cylindre étanche 14 rempli au moins partiellement d'un matériau 15 adapté à se dilater lorsqu'il est chauffé, une tige 16 coulissant dans le cylindre 14 entre une position étendue dans laquelle l'amène le matériau 15 lorsqu'il se dilate et une position rétractée dans laquelle elle est amenée lorsque le matériau 15 se contracte, et des moyens d'élévation de température adaptés à chauffer le matériau 15 pour amener la tige 16 dans la positon étendue.

Le matériau 15 est ici une cire naturelle ou une cire synthétique.

Les moyens d'élévation de température de chaque actionneur 10 comportent une résistance 18 présentant une forme filaire et qui s'étend sur la longueur du cylindre 14 en entourant le cylindre 14 de l'actionneur 10. Lorsqu'un courant électrique de commande circule dans la résistance 18 par application d'une tension de commande Vc aux bornes de la résistance 18, la résistance 18 produit de la chaleur qui chauffe le matériau 15. Le matériau 15 se dilate alors dans le cylindre 14, ce qui amène la tige 16 de l'actionneur 10 dans la position étendue. Lorsqu'aucun courant électrique ne circule dans la résistance 18, le matériau 15 se refroidit et se contracte, ce qui permet à la tige 16 de revenir vers sa position rétractée. Une élévation de température d'environ 40°C permet d'amener la tige 16 dans la position étendue depuis la position rétractée.

Le basculeur intermédiaire 11, quant à lui, comporte un moyeu 20, un premier ergot 21 et un deuxième ergot 22 s'étendant symétriquement en saillie latérale du moyeu 20.

Le moyeu 20 présente une forme extérieure cylindrique de section circulaire d'axe Y parallèle aux axes de pivotement X, X' de la lame 6. L'axe Y est fixé libre en pivotement sur la même face interne 9 que les axes X et X' et s'étend perpendiculairement à ladite face interne 9. Le premier ergot 21 et le deuxième ergot 22 s'étendent, à l'extérieur du moyeu 20, dans un même plan perpendiculaire à la face interne 9 du boîtier 2 du compteur 1. Le premier ergot 21 et le deuxième ergot 22 comportent chacun une base 23, la base 23 du premier ergot 21 et la base 23 du deuxième ergot 22 étant positionnées sur le moyeu 20 en étant diamétralement opposées l'une à l'autre.

Le premier ergot 21 est solidaire de la deuxième extrémité 8 de la lame 6.

Lorsque la tige 16 du premier actionneur 10a s'étend, sous l'effet de la dilatation du matériau 15 du cylindre 14 du premier actionneur 10a provoquée par le réchauffement du matériau 15, et vient dans la position étendue, la tige 16 du premier actionneur 10a exerce un effort sur le premier ergot 21 et entraîne en rotation le basculeur intermédiaire 11 dans le sens trigonométrique. La deuxième extrémité 8 de la lame 6 vient alors dans la position haute et la lame 6 prend la forme de connexion. Le deuxième ergot 22 tourne aussi dans le sens trigonométrique et exerce un effort sur la tige 16 du deuxième actionneur 10b qui se rétracte et vient en position rétractée, ce qui est rendu possible par le fait que le matériau 15 du cylindre 14 du deuxième actionneur 10b n'est pas chauffé et est contracté. Une tension de commande Vc appliquée aux bornes de la résistance 18 des moyens d'élévation de température du premier actionneur 10a permet donc d'amener la lame 6 dans la position de connexion et donc de connecter entre elles les bornes 4.

Au contraire, lorsque la tige 16 du deuxième actionneur 10b s'étend, sous l'effet de la dilatation du matériau 15 du cylindre 14 du deuxième actionneur 10b provoquée par le réchauffement du matériau 15, et vient dans la position étendue, la tige 16 du deuxième actionneur 10b exerce un effort sur le deuxième ergot 22 et entraîne en rotation le basculeur 11 dans le sens inverse du sens trigonométrique. La deuxième extrémité 8 de la lame 6 vient alors dans la position basse et la lame 6 prend la forme de déconnexion. Le premier ergot 21 tourne aussi dans le sens inverse du sens trigonométrique et exerce une pression sur la tige 16 du premier actionneur 10a qui est déplacée vers sa position rétractée, ce qui est rendu possible par le fait que le matériau 15 du cylindre 14 du premier actionneur 10a n'est pas chauffé et est contracté. Une tension de commande Vc appliquée aux bornes de la résistance 18 des moyens d'élévation de température du deuxième actionneur 10b permet donc d'amener la lame 6 dans la position de déconnexion et donc de déconnecter les bornes 4 l'une de l'autre.

Avantageusement, l'organe de coupure 3 comporte en outre des moyens d'amortissement adaptés à absorber des variations simultanées de volume du matériau 15 du cylindre 14 du premier actionneur 10a et du matériau 15 du cylindre 14 du deuxième actionneur 10b, lesdites variations simultanées de volume résultant de variations de conditions externes telles que des variations d'une température ambiante.

En effet, dans le cas par exemple d'une élévation de la température ambiante, une dilatation simultanée et similaire du matériau 15 du cylindre 14 du premier actionneur 10a et du matériau 15 du cylindre 14 du deuxième actionneur 10b produit une extension simultanée de la tige 16 du premier actionneur 10a et de la tige 16 du deuxième actionneur 10b. Cette extension simultanée génère un effort sur le basculeur intermédiaire 11 et, en réaction, un effort sur l'intérieur des cylindres 14, lesdits efforts étant susceptibles de fragiliser le premier actionneur 10a, le deuxième actionneur 10b et le basculeur intermédiaire 11. Dans ce cas, les moyens d'amortissement permettent de limiter l'effet de l'extension simultanée de la tige 16 du premier actionneur 10a et de la tige 16 du deuxième actionneur 10b.

Les moyens d'amortissement comportent ici un support mobile 25 sur lequel sont montés le cylindre 14 du premier actionneur 10a et le cylindre 14 du deuxième actionneur 10b, et un ressort 26 comportant une première extrémité fixée au boîtier 2 du compteur 1 et une deuxième extrémité solidaire du support mobile 25. Ainsi, lorsque la tige 16 du premier actionneur 10a et la tige 16 du deuxième actionneur 10b subissent une extension simultanée, l'effort généré sur les cylindres 14 tend à enfoncer le support mobile 25 grâce au ressort 26 qui absorbe cet enfoncement. De même, lorsque la tige 16 du premier actionneur 10a et la tige 16 du deuxième actionneur 10b subissent une rétraction simultanée, le ressort 26 tend à compenser cette rétraction en déplaçant le support mobile 25 vers le basculeur intermédiaire 11, le déplacement étant rendu possible par le ressort 26.

Avantageusement à nouveau, on espace le cylindre 14 du premier actionneur 10a et le cylindre 14 du deuxième actionneur 10b d'une distance D comprise entre 1mm et 15mm. Le cylindre 14 du premier actionneur 10a et le cylindre 14 du deuxième actionneur 10b sont séparés par de l'air. Dans cette configuration, l'élévation de température du matériau 15 provoquée par l'application d'une tension de commande Vc aux bornes de la résistance 18 de l'un des actionneurs 10 ne réchauffe pas le matériau 15 du cylindre 14 de l'autre actionneur 10 de manière significative. Cette configuration permet en outre d'obtenir une évacuation efficace de la chaleur provenant d'un cylindre 14 dont le matériau 15 n'est plus chauffé et se refroidit (car la tension de commande Vc n'est plus appliquée).

Bien entendu, l'invention n'est pas limitée au mode de réalisation décrit mais englobe toute variante entrant dans le champ de l'invention telle que définie par les revendications.

Le matériau à l'intérieur du cylindre de chaque actionneur adapté à se dilater sous l'effet d'une élévation de température peut parfaitement être un matériau différent, par exemple un gaz inerte (et donc non inflammable). On joue alors sur les variations de pression du gaz résultant de variations de la température.

Bien que l'on ait indiqué que la résistance des moyens d'élévation de température présente la forme d'un fil enroulé autour du cylindre, il est possible d'utiliser un composant résistif de forme différente et positionné différemment (par exemple à l'intérieur du cylindre).

Le compteur peut tout aussi bien être un compteur multi-phases, auquel cas on disposera d'autant d'organes de coupure du même type de l'invention que de phases dans le compteur.

## Revendications

1. Organe de coupure destiné à sélectivement connecter entre elles et déconnecter deux bornes (4) d'un circuit électrique, l'organe de coupure comportant :
- une lame déformable (6) adaptée à prendre une forme stable de connexion dans laquelle une première extrémité (7) de la lame déformable est agencée pour connecter entre elles les deux bornes et une forme stable de déconnexion dans laquelle la première extrémité est agencée pour déconnecter les deux bornes ;
- un premier actionneur (10a) et un deuxième actionneur (10b) qui sont commandés thermiquement et qui sont agencés pour agir de manière antagoniste sur une deuxième extrémité (8) de la lame déformable pour déformer la lame déformable, de sorte que le premier actionneur est adapté à amener la lame déformable dans la forme stable de connexion et le deuxième actionneur est adapté à amener la lame déformable dans la forme stable de déconnexion.

2. Organe de coupure selon la revendication 1, dans lequel la lame déformable comprend deux axes de pivotement (X, X') fixes et parallèles entre eux, une distance (d) entre les deux axes de pivotement étant inférieure à une longueur (1) de la lame déformable entre les deux axes de pivotement.

3. Organe de coupure selon la revendication 1, dans lequel chaque actionneur parmi le premier actionneur et le deuxième actionneur comporte un cylindre (14) rempli au moins partiellement d'un matériau (15) adapté à se dilater lorsqu'il est chauffé, une tige (16) coulissant dans le cylindre entre une position étendue dans laquelle elle est amenée lorsque le matériau se dilate et une position rétractée dans laquelle elle est amenée lorsque le matériau se contracte, et des moyens d'élévation de température adaptés à chauffer le matériau pour amener la tige dans la positon étendue.

4. Organe de coupure selon la revendication 3, dans lequel les moyens d'élévation de température comportent un composant résistif (18) qui chauffe le matériau lorsque le composant résistif est parcouru par un courant électrique.

5. Organe de coupure selon la revendication 4, dans lequel le composant résistif (18) entoure au moins partiellement le cylindre (14).

6. Organe de coupure selon la revendication 3, dans lequel le matériau comporte une cire naturelle ou une cire synthétique.

7. Organe de coupure selon la revendication 3, dans lequel le matériau comporte un gaz inerte.

8. Organe de coupure selon la revendication 3, comportant en outre des moyens d'amortissement adaptés à absorber des variations simultanées de volume du matériau du cylindre du premier actionneur et du matériau du cylindre du deuxième actionneur, lesdites variations simultanées de volume résultant de variations de conditions externes telles que des variations d'une température ambiante.

9. Organe de coupure selon la revendication 8, dans lequel les moyens d'amortissement comportent un support mobile (25) sur lequel sont montés le cylindre du premier actionneur et le cylindre du deuxième actionneur et un ressort (26) comportant une première extrémité fixe et une deuxième extrémité solidaire du support mobile.

10. Organe de coupure selon la revendication 1, dans lequel le premier actionneur et le deuxième actionneur sont espacés d'une distance (D) comprise entre 1mm et 15mm.

11. Organe de coupure selon l'une des revendications précédentes, dans lequel le premier actionneur et le deuxième actionneur agissent sur la deuxième extrémité de la lame déformable via un basculeur intermédiaire (11).

12. Organe de coupure selon la revendication 11, dans lequel le premier actionneur entraîne en rotation le basculeur intermédiaire dans un premier sens de rotation pour amener la lame déformable dans la forme stable de connexion et dans lequel le deuxième actionneur entraîne en rotation le basculeur intermédiaire dans un deuxième sens de rotation inverse du premier sens de rotation pour amener la lame déformable dans la forme stable de déconnexion.

13. Organe de coupure selon la revendication 12, dans lequel le basculeur intermédiaire comporte un axe de rotation (Y) fixé libre en pivotement sur une même face interne (9) que les deux axes de pivotement (X, X') de la lame déformable (6).

14. Compteur électrique destiné à mesurer une quantité d'énergie électrique transmise via une ligne électrique comprenant au moins un conducteur, le compteur électrique comprenant un organe de coupure selon l'une quelconque des revendications précédentes, destiné à être monté sur le conducteur.

## Patentansprüche

1. Schaltelement, das dazu bestimmt ist, zwei Anschlussklemmen (4) eines elektrischen Stromkreises selektiv miteinander zu verbinden und zu trennen, wobei das Schaltelement umfasst:
- ein verformbares Blatt (6), das geeignet ist, eine stabile Verbindungsform anzunehmen, in der ein erstes Ende (7) des verformbaren Blattes so angeordnet ist, dass es die beiden Anschlussklemmen miteinander verbindet, sowie eine stabile Trennform, in der das erste Ende so angeordnet ist, dass es die beiden Anschlussklemmen trennt;
- einen ersten Aktor (10a) und einen zweiten Aktor (10b), die thermisch gesteuert werden und so ausgebildet sind, dass sie auf antagonistische Weise auf ein zweites Ende (8) des verformbaren Blattes einwirken, um das verformbare Blatt zu verformen, so dass der erste Aktor geeignet ist, das verformbare Blatt in die stabile Verbindungsform zu bringen, und der zweite Aktor geeignet ist, das verformbare Blatt in die stabile Trennform zu bringen.

2. Schaltelement nach Anspruch 1, bei dem das verformbare Blatt zwei Schwenkachsen (X, X') umfasst, die ortsfest und parallel zueinander sind, wobei ein Abstand (d) zwischen den beiden Schwenkachsen kleiner als eine Länge (I) des verformbaren Blattes zwischen den beiden Schwenkachsen ist.

3. Schaltelement nach Anspruch 1, bei dem jeder Aktor von dem ersten Aktor und dem zweiten Aktor einen Zylinder (14) umfasst, der zumindest teilweise mit einem Material (15) gefüllt ist, das dazu geeignet ist, sich auszudehnen, wenn es erwärmt wird, eine Stange (16), die sich in dem Zylinder zwischen einer ausgefahrenen Position, in die sie gebracht wird, wenn sich das Material ausdehnt, und einer eingefahrenen Position verschiebt, in die sie gebracht wird, wenn sich das Material zusammenzieht, sowie Temperaturerhöhungsmittel, die geeignet sind, das Material zu erwärmen, um die Stange in die ausgefahrene Position zu bringen.

4. Schaltelement nach Anspruch 3, bei dem die Temperaturerhöhungsmittel ein Widerstandsbauelement (18) umfassen, das das Material erwärmt, wenn das Widerstandsbauelement von einem elektrischen Strom durchflossen wird.

5. Schaltelement nach Anspruch 4, bei dem das Widerstandsbauelement (18) den Zylinder (14) zumindest teilweise umgibt.

6. Schaltelement nach Anspruch 3, bei dem das Material ein natürliches Wachs oder ein synthetisches Wachs umfasst.

7. Schaltelement nach Anspruch 3, bei dem das Material ein Inertgas umfasst.

8. Schaltelement nach Anspruch 3, ferner umfassend Dämpfungsmittel, die geeignet sind, gleichzeitige Volumenveränderungen des Materials des Zylinders des ersten Aktors und des Materials des Zylinders des zweiten Aktors zu absorbieren, wobei die genannten gleichzeitigen Volumenveränderungen aus Veränderungen äußerer Bedingungen, wie z. B. Veränderungen einer Umgebungstemperatur resultieren.

9. Schaltelement nach Anspruch 8, bei dem die Dämpfungsmittel einen beweglichen Träger (25) umfassen, auf dem der Zylinder des ersten Aktors und der Zylinder des zweiten Aktors gelagert sind, sowie eine Feder (26), die ein ortsfestes erstes Ende und ein fest mit dem beweglichen Träger verbundenes zweites Ende umfasst.

10. Schaltelement nach Anspruch 1, bei dem der erste Aktor und der zweite Aktor um einen Abstand (D) beabstandet sind, der zwischen 1 mm und 15 mm liegt.

11. Schaltelement nach einem der vorhergehenden Ansprüche, bei dem der erste Aktor und der zweite Aktor über eine dazwischenliegende Kippvorrichtung (11) auf das zweite Ende des verformbaren Blattes einwirken.

12. Schaltelement nach Anspruch 11, bei dem der erste Aktor die dazwischenliegende Kippvorrichtung in eine erste Drehrichtung drehend antreibt, um das verformbare Blatt in die stabile Verbindungsform zu bringen, und bei dem der zweite Aktor die dazwischenliegende Kippvorrichtung in eine zur ersten Drehrichtung umgekehrte zweite Drehrichtung drehend antreibt, um das verformbare Blatt in die stabile Trennform zu bringen.

13. Schaltelement nach Anspruch 12, bei dem die dazwischenliegende Kippvorrichtung eine Drehachse (Y) hat, die frei schwenkbar auf einer selben Innenseite (9) wie die beiden Schwenkachsen (X, X') des verformbaren Blattes (6) befestigt ist.

14. Elektrischer Zähler, der dazu bestimmt ist, eine elektrische Energiemenge zu messen, die über eine elektrische Leitung übertragen wird, die mindestens einen Leiter umfasst, wobei der elektrische Zähler ein Schaltelement nach einem der vorhergehenden Ansprüche umfasst, das dazu bestimmt ist, an dem Leiter angebracht zu werden.

## Claims

1. A disconnect member for selectively connecting together and disconnecting two terminals (4) of an electrical circuit, the disconnect member comprising:
• a deformable blade (6) adapted to take up a stable connection shape in which a first end (7) of the deformable blade is arranged to connect together the two terminals, and a stable disconnection shape in which the first end is arranged to disconnect the two terminals; and
• a first actuator (10a) and a second actuator (10b) that are thermally controlled and that are arranged to act in opposite manner on a second end (8) of the deformable blade in order to deform the deformable blade, in such a manner that the first actuator is adapted to take the deformable blade into the connection stable shape and the second actuator is adapted to take the deformable blade into the disconnection stable shape.

2. A disconnect member according to claim 1, wherein the deformable blade has two pivot pins (X, X') that are stationary and parallel to each other, the distance (d) between the two pivot pins being shorter than the length (ℓ) of the deformable blade between the two pivot pins.

3. A disconnect member according to claim 1, wherein each actuator selected from the first actuator and the second actuator comprises a cylinder (14) filled at least in part with a material (15) that is adapted to expand on being heated, a rod (16) sliding in the cylinder between an extended position into which it is taken when the material expands, and a retracted position into which it is taken when the material contracts, and temperature-raising means adapted to heat the material in order to take the rod into the extended position.

4. A disconnect member according to claim 3, wherein the temperature-raising means comprise a resistive component (18) that heats the material when the resistive component passes an electric current.

5. A disconnect member according to claim 4, wherein the resistive component (18) surrounds the cylinder (14) at least in part.

6. A disconnect member according to claim 3, wherein the material comprises natural wax or synthetic wax.

7. A disconnect member according to claim 3, wherein the material comprises an inert gas.

8. A disconnect member according to claim 3, further including damper means adapted to absorb simultaneous variations in the volume of the material in the cylinder of the first actuator and of the material in the cylinder of the second actuator, said simultaneous variations of volume resulting from variations in external conditions, such as variations in ambient temperature.

9. A disconnect member according to claim 8, wherein the damper means comprise a movable support (25) on which the cylinder of the first actuator and the cylinder of the second actuator are mounted, and a spring (26) having a first end stationary and a second end secured to said movable support.

10. A disconnect member according to claim 1, wherein the first actuator and the second actuator are spaced apart by a distance (D) lying in the range 1 mm to 15 mm.

11. A disconnect member according to any preceding claim, wherein the first actuator and the second actuator act on the second end of the deformable blade via an intermediate rocker (11).

12. A disconnect member according to claim 11, wherein the first actuator turns the intermediate rocker in a first direction in order to take the deformable blade into the stable connection shape, and wherein the second actuator turns the intermediate rocker in a second direction opposite to the first direction in order to take the deformable blade into the stable disconnection shape.

13. A disconnect member according to claim 12, wherein the intermediate rocker includes a pivot pin (Y) fastened free to pivot to an inside face (9) in common with the two pivot pins (X, X') of the deformable blade (6) .

14. An electricity meter for measuring a quantity of electrical energy transmitted via an electricity line comprising at least one conductor, the electricity meter including a disconnect member according to any preceding claim for mounting in series with the conductor.
